Europäisches Patentamt

European Patent Office

Office européen des brevets

(11) Numéro de publication : **0 490 752 A1**

# (12) DEMANDE DE BREVET EUROPEEN

(21) Numéro de dépôt : **91403332.9**

(51) Int. Cl.$^5$ : **H03K 17/30, H03K 3/353**

(22) Date de dépôt : **09.12.91**

(30) Priorité : **14.12.90 FR 9015721**

(43) Date de publication de la demande :
**17.06.92 Bulletin 92/25**

(84) Etats contractants désignés :
**BE CH DE ES FR GB IT LI NL SE**

(71) Demandeur : **BULL S.A.**
**121, Avenue de Malakoff**
**F-75116 Paris (FR)**

(72) Inventeur : **Neu, Georges**
**121, avenue de Malakoff, PC 8M006**
**F-75116 Paris (FR)**
Inventeur : **Ahn, Claude**
**121, avenue de Malakoff, PC 8M006**
**F-75116 Paris (FR)**

(74) Mandataire : **Denis, Hervé et al**
**121, avenue de Malakoff, PC 8M006**
**F-75116 Paris (FR)**

(54) **Procédé et circuit de déclenchement à seuil.**

(57)    Le procédé de déclenchement à seuil d'un signal de transmission E consiste à attribuer deux valeurs de seuil de déclenchement S1 et S2 pour la montée et la descente du signal E et à valider le déclenchement sur chacune des deux tensions de seuil S1 et S2.

Le circuit à seuil comprend deux amplificateurs à seuil A1 et A2 recevant le même signal de transmission E. Les voies de sortie V1 et V2 des amplificateurs sont sélectionnées par un multiplexeur MUX (14), lui-même commandé par un circuit pilote CP (16). Les seuils S1 et S2 des amplificateurs A1 et A2 sont respectivement choisis assez proches des niveaux "haut" et "bas" du signal E.

L'invention est surtout avantageuse en association avec une ligne de transmission de signaux entre circuits intégrés CMOS de type VLSI, ou avec des liaisons fortement capacitives.

FIG_1

EP 0 490 752 A1

La présente invention concerne un procédé de déclenchement à seuil et un circuit électronique à seuil particulièrement adapté à une intégration de type VLSI (Very Large Scale Integration) et utilisable notamment en association avec des lignes électriques de transmission de signaux entre circuits intégrés ou avec des liaisons intérieures ou extérieures de forte capacité.

Les liaisons électriques reliant un circuit intégré à un composant extérieur, un autre circuit intégré par exemple, peuvent constituer de véritables lignes électriques pour les signaux de très haute fréquence actuellement utilisés. Un signal, par exemple de forme rectangulaire, est susceptible d'être déformé selon la position du point de branchement sur la ligne, la longueur de celle-ci (définissant le temps de propagation $\theta$ de l'onde parcourant toute la ligne) et l'équilibrage électrique de la ligne. Si, à l'autre extrémité de la ligne, le signal demeure rectangulaire mais décalé du temps $\theta$, la réflexion de l'onde en bout de ligne entraîne la formation d'un gradin d'une durée maximale de 2 $\theta$ pour le signal présent sur la ligne en un point intermédiaire. Selon l'équilibrage de la ligne, la tension correspondante à ce gradin est susceptible de varier autour de la position à mi-hauteur du front du signal correspondant à la tension d'alimentation du circuit. Cette situation est gênante en ce qu'elle entraîne une imprécision au niveau de l'instant de déclenchement des circuits récepteurs avec parfois des retards importants et inacceptables pour beaucoup d'applications actuelles des circuits intégrés. En particulier, les circuits à seuil disposés à l'entrée de circuits intégrés et destinés à remettre en forme les signaux reçus avant leur exploitation ultérieure sont souvent constitués par des amplificateurs à seuil centré (c'est-à-dire dont le seuil de déclenchement est choisi à mi-hauteur de la tension d'alimentation) pour être utilisés avec la même efficacité lors d'un passage d'un front montant ou d'un front descendant d'un signal de transmission. De tels circuits sont très sensibles à ce phénomène d'établissement de signal en gradin.

Par ailleurs, certaines liaisons électriques peuvent présenter une capacité électrique suffisamment importante pour accroître très sensiblement la durée d'établissement des fronts (montant ou descendant) des signaux transmis. Il en résulte une augmentation importante du temps nécessaire pour atteindre le seuil de déclenchement de l'amplificateur.

L'invention a pour but de commander avec précision l'instant de déclenchement d'un circuit à seuil. A cet effet, l'invention propose un procédé de déclenchement à seuil d'un signal de transmission E variant entre deux niveaux, respectivement "haut" ou "1" et "bas" ou "0", caractérisé en ce qu'il consiste à attribuer deux tensions de seuil de déclenchement S1 et S2, différentes pour la montée et la descente du signal E et choisies respectivement proches des niveaux "haut" et "bas" du signal E, et à valider le déclenchement sur chacune des deux tensions de seuil S1 et S2.

A titre de variantes du procédé de l'invention, la validation du déclenchement est effectuée sur S2 à la montée et sur S1 à la descente du signal pour un déclenchement précoce ou sur S1 à la montée et sur S2 à la descente pour un déclenchement tardif. Il est ainsi possible d'obtenir des déclenchements précoces ou tardifs, au choix de l'utilisateur, tant à aller qu'au retour.

Selon une autre variante du procédé de l'invention, la validation est commandée par introduction d'un retard TR suivant le déclenchement sur une des deux tensions de seuil, le retard TR étant, pour un déclenchement précoce, choisi supérieur ou égal au temps écoulé entre les passages du signal de transmission E sur les deux valeurs de seuil successives d'un même front montant FM ou descendant FD.

Selon encore une autre variante du procédé de l'invention, la validation a lieu lorsque le signal de transmission atteint une tension de validation de montée TVM ou de descente TVD, ces deux tensions de validation étant définies par les fronts de montée et de descente d'une courbe d'hystérésis. Pour un déclenchement précoce, la tension de validation de montée TVM est choisie supérieure ou égale à la tension de seuil S1 et la tension de validation de descente TVD est choisie inférieure ou égale à la tension de seuil S2.

L'invention concerne également des circuits à seuil dont le déclenchement est conforme au procédé de l'invention présenté ci-dessus dans ses diverses variantes.

Un circuit à seuil conforme à l'invention comprend deux amplificateurs A1, A2 à seuils de déclenchement différents S1, S2, recevant un signal de transmission E et montés en parallèle sur deux voies V1, V2 connectées aux entrées respectives d'un multiplexeur MUX, qui est commandé par un circuit pilote CP pour sélectionner l'une ou l'autre des voies V1, V2 selon le front montant FM ou descendant FD du signal de transmission E et pour valider le déclenchement de l'amplificateur, qui est inclus dans la voie sélectionnée V1, V2, sur la tension de seuil correspondante S1, S2.

Avantageusement, les valeurs des seuils S2 et S1 des amplificateurs A1, A2 des voies V2 et V1 sont respectivement choisies au voisinage des niveaux "bas" et "haut" du signal de transmission E.

Selon une première variante du circuit à seuil de l'invention, le circuit pilote CP commande le multiplexeur MUX pour maintenir la sélection d'une voie V1, V2, après déclenchement de l'amplificateur correspondant A1, A2 au passage du signal de transmission E sur le seuil S1, S2 correspondant, pendant un temps de retard TR qui, pour un déclenchement précoce, est au moins égal au temps écoulé entre les passages du signal E sur les deux valeurs de seuil successives sur un même front montant FM ou descendant FD. Avantageusement, le circuit pilote CP du multiplexeur MUX est du type circuit à retard et, de façon optionnelle, commandé à partir des signaux de sortie des amplificateurs.

Selon une seconde variante du circuit à seuil de l'invention, le multiplexeur MUX est commandé par le signal de sortie d'un circuit pilote CP du type à hystérésis, dont l'entrée reçoit le signal de transmission E. Avantageusement, le circuit pilote CP est du type à bascule de Schmitt dont les tensions de basculement en montée et descente sont choisies de préférence sensiblement égales aux tensions de validation montée et descente TVM et TVD.

Selon un autre aspect du circuit à seuil de l'invention le multiplexeur MUX comprend deux dispositifs de commutation travaillant en opposition et respectivement montés sur les voies V1 et V2. Avantageusement les dispositifs de commutation sont constitués par deux transistors MOS, un transistor de type N et un transistor de type P dont les grilles sont connectées à la même ligne de sortie du circuit pilote CP, de façon optionnelle au travers d'un circuit tampon T constitué d'au moins un inverseur CMOS.

Les caractéristiques et avantages de la présente invention apparaîtront à la lecture de la description qui va suivre, donnée à titre d'exemple et faite en référence aux dessins annexés.

Dans les dessins :

– la figure 1 est une représentation schématique d'un premier mode de réalisation d'un circuit à seuil selon l'invention,

– la figure 2 est une représentation schématique d'un chronogramme des signaux d'entrée E et de sortie S du circuit à seuil des figures 1 et 2 et du circuit à seuil des figures 4 et 5,

– la figure 3 est une représentation schématique d'un mode de réalisation en technologie CMOS du circuit à seuil de la figure 1,

– la figure 4 est une représentation schématique d'un second mode de réalisation d'un circuit à seuil selon l'invention,

– et la figure 5 est une représentation schématique d'un mode de réalisation en technologie CMOS du circuit à seuil de la figure 4.

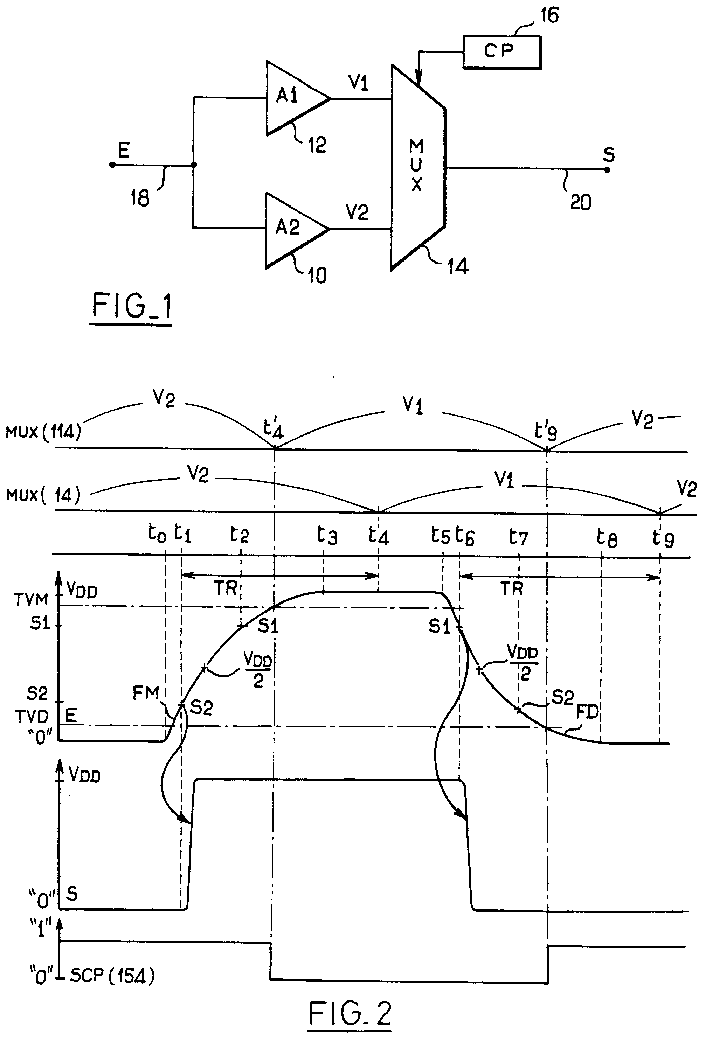

Le circuit à seuil de l'invention qui est illustré schématiquement à la figure 1 comprend deux dispositifs à seuil tels que des amplificateurs à seuil A1 et A2 (10, 12) montés en parallèle sur deux voies V1 et V2 respectivement connectées aux entrées d'un multiplexeur MUX 14 commandé par un circuit pilote CP 16. Les deux amplificateurs A1 et A2 sont susceptibles de recevoir le même signal d'entrée E à partir d'une ligne de transmission 18. Le multiplexeur MUX délivre un signal de sortie S sur une ligne de sortie 20 convenablement connectée à des circuits de traitement (non représentés).

Un tel circuit à seuil, qui sera présenté en détail ultérieurement, permet la mise en oeuvre du procédé de déclenchement selon l'invention. Plus précisément, les amplificateurs A1 et A2 ont des seuils de déclenchement distincts S1 et S2 compris entre les niveaux de tension "haut"/"1" et "bas"/"0" du signal E. Le multiplexeur 14 a pour fonction de sélectionner une des voies V1 et V2, selon la descente ou la montée du signal E et ainsi de valider le déclenchement du circuit sur chacune des tensions de seuil S1 et S2.

Pour obtenir un circuit à seuil à déclenchement précoce, le seuil S2 de l'amplificateur A2, destiné à être sélectionné lors du passage d'un front montant FM du signal E, est choisi au voisinage du niveau "bas" de ce même signal, tandis que le seuil S1 de l'amplificateur A1, destiné à être sélectionné lors du passage d'un front descendant FD du signal E est choisi au voisinage du niveau "haut" de ce même signal. Le chronogramme de la figure 2 illustre la représentation en tension des signaux E et S en fonction du temps. On peut remarquer que l'allure du signal reçu E montre des fronts d'établissement très progressifs difficilement exploitables directement. Antérieurement à l'invention, un unique amplificateur à seuil centré à VDD/2 était utilisé pour générer le signal de sortie. Toutefois, cette solution entraîne un retard parfois important dans l'établissement du signal de sortie par rapport à celui du signal d'entrée. Ce retard est de l'ordre de la moitié du temps d'établissement des fronts du signal E pour une liaison 18 fortement capacitive, ou est supérieur au temps correspondant du gradin dans le signal issu d'une ligne électrique.

Le mode opératoire du circuit de la figure 1 va maintenant être présenté dans son principe en référence au chronogramme de la figure 2 qui illustre, à titre d'exemple non limitatif, l'allure d'un signal de transmission E à la réception sur une ligne de transmission capacitive. Au repos, le signal E est à son niveau de référence "zéro" (niveau "bas"). Les amplificateurs A1 et A2 étant tous deux bloqués, le signal de sortie S a aussi le niveau "0". Le multiplexeur MUX 14 est commandé par le circuit pilote CP 16 pour inhiber V1 et pour valider V2 et, par conséquent, le déclenchement de l'amplificateur à seuil A2 (voir à la figure 2 le graphe MUX(14)). A l'instant t0 arrive le front montant FM de E vers le niveau "haut" (VDD). Le signal S reste inchangé. A t1, le signal E a la valeur du seuil S2, de sorte que la sortie de l'amplificateur A2 prend le niveau "1". Ce niveau est transmis par la voie V2 et par le multiplexeur 14, de sorte que le signal de sortie S prend le niveau "1". A t2, le signal E a la valeur du seuil S1 et la sortie de l'amplificateur A1 prend le niveau "1". A partir de cet instant t2 les voies V1 et V2 ont les mêmes niveaux, de sorte que MUX 14 peut être commandé pour commuter la sélection des voies V1 et V2. Une commutation antérieure à l'instant t2 provoquerait une oscillation indésirable du signal S, par retour prématuré au niveau "0" et son maintien à ce niveau jusqu'à l'instant t2 où le signal E prend la valeur du seuil S1. A l'instant t3, le signal E prend le niveau "1". Dans l'exemple illustré dans la figure 2, la commutation du multiplexeur 14 par le circuit pilote CP 16 a lieu à ce niveau "1" du signal E à l'instant t4. La voie V2 est alors inhibée, la voie V1 validée, le signal S conservé au niveau "1" et le déclenchement de A1 validé. A l'instant t5 commence le front descendant FD du signal E. A l'instant t6 le signal E passe au niveau du seuil S1, de sorte que la sortie de l'amplificateur A1 prend la valeur "0". Ce niveau est transmis par la voie V1 et par le multiplexeur MUX 14, de sorte que le signal S prend aussi la valeur "0". A l'instant t7 le signal E passe au seuil S2 et la sortie de l'amplificateur prend le niveau "0". A partir de cet instant, pour les mêmes raisons que précédemment, le multiplexeur MUX 14 peut être commandé par le circuit pilote 16 pour commuter la sélection des voies. A l'instant t8, le signal de transmission E arrive à son niveau "0". Enfin à t9 le multiplexeur MUX 14 commute pour inhiber la voie V1 et valider la voie V2. Le signal de sortie S conserve son niveau "0" et le déclenchement de A2 est à nouveau validé.

Par conséquent, par rapport à un amplificateur à seuil centré, le circuit à deux seuils selon l'invention permet la reconfiguration précoce du signal E reçu. Le choix des seuils S1 et S2 respectivement au voisinage des niveaux "haut" et "bas" du signal de transmission E permet de réduire sensiblement les temps de réponse (t0 - t1 et t5 - t6) du circuit à seuil entre les signaux d'entrée E et de sortie S. Dans la pratique, le choix du seuil S2 dépend notamment du niveau de bruit dans le signal d'entrée E. De plus les instants d'établissement des signaux S sont légèrement décalés par rapport aux instants t1 et t6 du fait du multiplexeur MUX 14. Si le signal E est issu d'une ligne électrique, le déclenchement peut donc avoir lieu avant la formation du gradin.

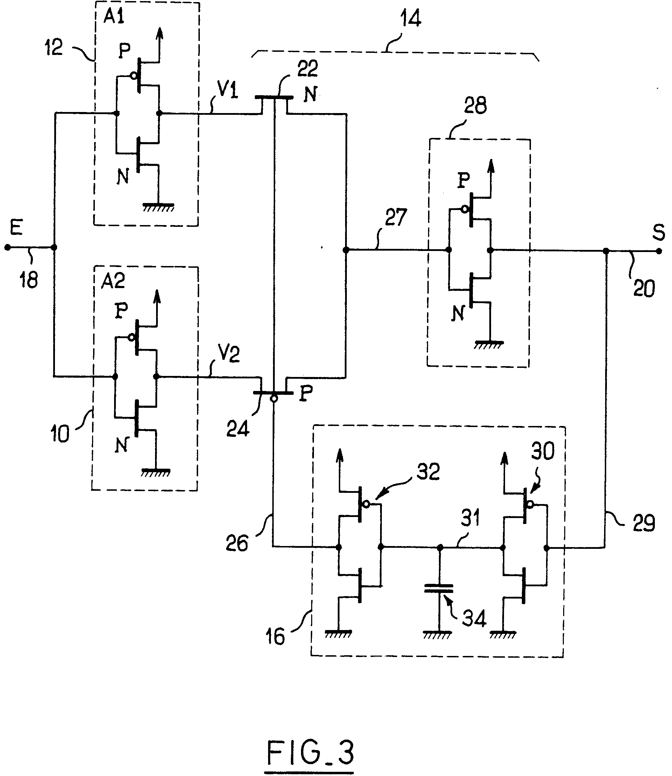

A titre d'exemple non limitatif, le circuit représenté à la figure 3 illustre un mode de réalisation pratique en technologie CMOS du circuit à seuil selon l'invention illustré à la figure 1.

Les deux amplificateurs à seuil A1 et A2 sont réalisés par des inverseurs CMOS 10 et 12 montés en parallèle sur la ligne d'entrée 18. Les inverseurs CMOS sont de type classique, faits chacun d'un montage en série d'un transistor P et d'un transistor N, la source du transistor P étant connectée à la borne d'alimentation en tension VDD (par exemple 5 volts), la source du transistor N étant connectée à la masse du circuit (0 volt). De plus, les grilles des transistors sont connectées à la borne d'entrée de l'inverseur CMOS tandis que les drains des deux transistors P et N sont connectés à la borne de sortie du même inverseur. La détermination de la valeur des seuils S1 et S2 est obtenue de manière classique, notamment à partir du choix du rapport des largeurs des grilles des transistors MOS (L(MOS)), l'inverseur commutant pour un seuil de tension d'autant plus bas que le rapport L(NMOS)/L(PMOS) est élevé. Les voies de sortie V1 et V2 des amplificateurs 12 et 10 sont connectées aux bornes d'entrée d'un multiplexeur 14 constitué essentiellement par une paire de transistors de commutation de type MOS 22, 24 travaillant en opposition sous le contrôle d'une ligne de commande 26 connectée à la sortie du circuit pilote CP 16. Plus précisemment, la voie V1 porte le transistor de commutation NMOS 22 tandis que la voie V2 porte le transistor de commutation PMOS 24, les grilles des deux transistors 22 et 24 étant directement connectées à la ligne de commande 26. Les transistors 22 et 24 sont montés en parallèle sur l'entrée 27 d'un inverseur CMOS 28 dont la sortie est connectée à la ligne 20 et délivre le signal S. L'inverseur 28 a pour fonction de supprimer l'effet d'inversion du signal engendré par les inverseurs 10 et 12 constituant les amplificateurs A1 et A2. Dans l'exemple de la figure 3, le circuit pilote CP 16 est un circuit à retard. La ligne 20 est connectée à l'entrée 29 du circuit de retard 16, lui-même constitué par deux inverseurs CMOS 30 et 32 montés en série en association avec un condensateur de charge 34 ayant une plaque à la masse et l'autre plaque connectée entre les deux inverseurs 30 et 32, comme illustré sur la figure 3.

Le mode opératoire du circuit représenté à la figure 3 va maintenant être présenté. Au repos, E = 0 (niveau "0"), les transistors N des inverseurs A1 et A2 sont bloqués tandis que les transistors P de ces mêmes inverseurs sont passants. Les drains des deux transistors P et N de chaque inverseur sont portés à la tension VDD. Ainsi, les voies V1 et V2 sont au niveau "1". Par ailleurs on verra que la grille du transistor PMOS 24 est portée au niveau "0", celui-ci étant donc conducteur et transmettant le niveau "1" à l'entrée de l'inverseur 28. Le transistor N de l'inverseur 28 est passant tandis que le transistor P associé est bloqué. La sortie 20 du circuit à seuil est donc portée au niveau "0". Il en est de même pour l'entrée 29 et la sortie 26 du circuit pilote CP 16 comportant les deux inverseurs 30 et 32 en série (le transistor P de l'inverseur 30 et le transistor N de l'inverseur 32 étant conducteurs, la ligne 31 au niveau "1" et le condensateur 34 chargé) de telle sorte que le transistor PMOS 24 est bien en mode passant tandis que le transistor NMOS 22, monté en opposition est bloqué. Pour résumer, le circuit se trouve dans l'état stable: E = S = "0", V2 = VDD = "1" sélectionnée et le déclenchement de A2 validé.

Après l'apparition en t0 du front montant FM du signal E, lorsque la valeur de la tension de grille aura atteint la valeur de seuil S2 (instant t1), l'inverseur 10 (amplificateur A2) commute avec N passant, P bloqué et V2 = "0". Ce niveau de tension de la voie V2 est porté à l'entrée 27 de l'inverseur 28, qui commute à son tour pour porter la ligne de sortie 20 au niveau "1".

Cette commutation se transmet à l'inverseur 30, qui commute également (transistor N) pour porter la ligne 31 au niveau "0". Toutefois, la présence du condensateur de charge 34 entraîne un retard TR dans l'établissement du niveau "0" à l'entrée de l'inverseur 32 (en raison du temps de décharge de ce condensateur). L'inverseur 32 commute à l'instant t4 = t1 + TR pour bloquer le transistor PMOS 24 et rendre passant le transistor NMOS 22. Ainsi la voie V1 est sélectionnée et le déclenchement de A1 est validé. Comme précisé auparavant lors de la présentation de la figure 2, l'inverseur A1 a alors déjà commuté (instant t2 antérieur à l'instant t4) de telle sorte que V1 = V2 = "0". Ainsi le niveau de sortie du signal S reste égal à "1". Pour résumer, le circuit se trouve dans un nouvel état stable: E = S = "1" et V1 sélectionnée par le transistor 22 du multiplexeur MUX 14.

Dès l'apparition en t5 du front descendant FD du signal E, le processus inverse se produit. En t6 (passage au seuil S1) l'amplificateur A1 12 commute pour porter pour porter V1 à "1" et S à "0". Similairement, la validation de la voie V2 sera différée de TR (instant t9 = t6 + TR) en raison du temps de charge du condensateur 34 lors de l'établissement du niveau "1" dans la ligne 31.

L'invention n'est pas limitée au circuit CMOS particulier ici décrit mais couvre d'autres réalisations de circuits à double seuil incorporant un multiplexeur, selon les principes généraux de réalisation et de fonctionnement présentés ci-dessus.

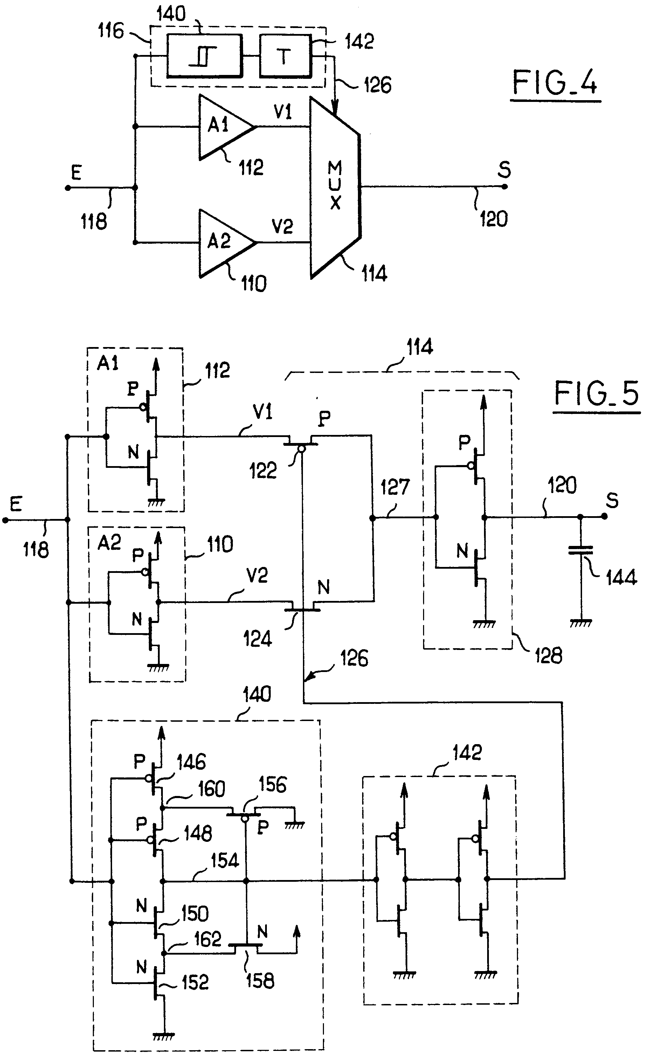

Les figures 4 et 5 se réfèrent à un autre mode de réalisation d'un circuit à seuil mettant également en oeuvre les principes de l'invention.

Le circuit à seuil de l'invention qui est illustré schématiquement à la figure 4 est sensiblement identique au circuit de la figure 1. Il comprend deux amplificateurs à seuil A1 et A2 (110, 112) montés en parallèle sur deux voies de sortie V1 et V2 respectivement connectées aux entrées d'un multiplexeur MUX 114 commandé par un circuit pilote CP 116 constitué d'un circuit du type à hystérésis 140 et optionnellement d'un circuit tampon T 142 destiné à réduire et à pratiquement éliminer les effets de couplage. Les deux amplificateurs A1 et A2 et l'entrée du circuit pilote 116 reçoivent le même signal d'entrée E d'une ligne de transmission 118. Le multiplexeur 114 délivre un signal de sortie S sur une ligne de sortie 120 convenablement connectée à des circuits de traitement (non représentés).

Comme précédemment, les amplificateurs A1 et A2 ont des seuils de déclenchement distincts S1 et S2 compris entre les niveaux "haut" ( "1" ou VDD) et "bas" ("0") du signal E. Le multiplexeur 114 a pour fonction de sélectionner une des voies V1 et V2 selon la descente ou la montée du signal E et ainsi de valider le déclenchement du circuit sur chacune des tensions de seuil S1 et S2.

Une fois encore, pour obtenir par exemple un circuit à seuil à déclenchement précoce, le seuil S2 de l'amplificateur A2, destiné à être validé lors du passage d'un front montant FM du signal E, est choisi au voisinage du niveau "bas" de ce même signal, tandis que le seuil S1 de l'amplificateur A1, destiné à être validé lors du passage d'un front descendant du signal E est choisi au voisinage du niveau "haut" de ce même signal.

Le mode opératoire du circuit de la figure 4 va maintenant être présenté rapidement en référence au chronogramme de la figure 2. Le mode opératoire est en effet très voisin de celui du circuit illustré dans la figure 1 et pour cette raison ne sera pas repris en détail. La différence essentielle existe au niveau du pilotage du multiplexeur MUX 114 et de la sélection des voies V1 et V2 par celui-ci (voir à la figure 2, le graphe repéré MUX(114)). Les fronts de montée et de descente du circuit à hystérésis 140 correspondent respectivement à une tension TVM (ici choisie assez proche de VDD) et à une tension TVD (ici choisie assez proche de "0"). Comme illustré dans la figure 2, on s'assure que la tension TVM reste supérieure ou égale à S1 et que la tension TVD reste inférieure à S2 (l'instant de commutation t'4 du multiplexeur MUX 114, correspondant à la sélection de la voie V1, est postérieur à t2 et l'instant de commutation t'9, correspondant à la sélection de V2, est postérieur à t7), ce qui élimine les risques d'oscillations parasites sur la ligne de sortie S 120.

A titre d'exemple non limitatif, le circuit représenté à la figure 5 illustre un mode de réalisation pratique en technologie CMOS du circuit à seuil selon l'invention illustré à la figure 4.

Les deux amplificateurs A1 et A2 sont réalisés par des inverseurs CMOS 110 et 112 montés en parallèle sur la ligne d'entrée 118. les inverseurs CMOS sont, comme précédemment décrits, de type classique, avec la source du transistor P connectée à la tension d'alimentation VDD (par exemple 5 volts) et la source du transistor N et connectée à la masse du circuit (niveau 0 volt). La géométrie et les dimensions des électrodes des grilles sont choisies pour obtenir un seuil de commutation "bas" S2 pour l'amplificateur A2 (commutation précoce sur le front montant FM) et un seuil de commutation "haut" S1 pour l'amplificateur A1 (commutation précoce sur le front descendant FD).

Les voies de sortie V1 et V2 des amplificateurs 112 sont connectées aux bornes d'entrée du multiplexeur 114 constitué essentiellement par une paire de transistors de commutation de type MOS 122, 124 travaillant en opposition sous le contrôle d'une ligne de commande 126 reliée à la sortie du circuit à hystérésis 140 au travers du circuit tampon T 142. Le circuit tampon T 142, constitué de deux inverseurs CMOS classiques montés en série, est monté de façon optionnelle sur la ligne 126 pour réaliser le découplage entre la sortie du circuit pilote 140 et les transistors MOS 122 et 124 et éliminer ainsi les effets capacitifs de ces derniers. Plus précisément, la voie V1 porte le transistor de commutation PMOS 122 tandis que la voie V2 porte le transistor de commutation NMOS 124, les grilles des deux transistors 122 et 124 étant directement connectées à la ligne 126. Les deux transistors 122 et 124 sont montés en parallèle sur l'entrée 127 d'un inverseur CMOS 128 connecté à la ligne de sortie 120 et délivrant un signal de sortie S. Comme illustrée dans la figure 5, la ligne de sortie 120 est pourvue d'une capacité de découplage 144.

Le circuit pilote comprend un circuit du type à hystérésis tel qu'une bascule de Schmitt 140 dans l'exemple illustré dans la figure 5. Cette bascule 140 comprend de manière classique, en premier rang, un montage série de deux transistors PMOS appariés 146 et 148 suivis de deux transistors NMOS appariés 150 et 152. Les grilles des quatre transistors MOS de premier rang reçoivent le signal de transmission E. La sortie 154 du circuit à hystérésis 140, prise entre les transistors de premier rang PMOS 148 et NMOS 150 adjacents, est reliée aux grilles de deux transistors respectivement PMOS 156 et NMOS 158 de second rang. Comme représenté sur la figure 5, le drain de chaque transistor MOS de second rang 156 (P) et 158 (N) est connecté à la borne de jonction 160 (transistors P) et 162 (transistors N) entre les deux transistors MOS de premier rang de même polarité P ou N. Leurs sources sont respectivement mises à la masse et à VDD. Le fonctionnement de la bascule 140 est bien connu.

Le mode opératoire du circuit représenté à la figure 5 va maintenant être présenté en référence également à la figure 2. Au repos, E = 0 (niveau = "0"), les transistors N des inverseurs A1 et A2 sont bloqués tandis que les transistors P de ces mêmes inverseurs sont passants. Les drains des deux transistors de chaque inverseur A1 et A2 sont portés à la tension VDD et les voies V1 et V2 sont au niveau "1". Par ailleurs, on verra que la grille du transistor NMOS 124 étant portée au niveau "1" par la ligne 126, ce transistor 124 est passant et transmet le niveau "1" à l'entrée de l'inverseur 128. Le transistor P associé est bloqué. La sortie S 120 du circuit à seuil est donc portée au niveau "0". En ce qui concerne le circuit à hystérésis 140, toutes les grilles des transistors de premier rang sont portées au niveau "0". Il en résulte que les deux transistors PMOS 146 et 148 sont passants et que les deux transistors NMOS 150 et 152 sont bloqués. La sortie 154 du circuit 140 est ainsi portée au niveau "1" (voir à la figure 2 le graphe SCP (154) ). Dans ces conditions, les transistors PMOS 156 et NMOS 158 sont bloqués. Cependant le transistor NMOS 158 est susceptible de conduire après déblocage du transistor NMOS 152. Le niveau "1" de la sortie 154 est transmis sur toute la ligne 126 au travers du circuit tampon T 142 constitué de deux inverseurs CMOS en série. Pour résumer, le circuit à seuil se trouve dans l'état stable : E = S = "0" et V2 = VDD = "1" validée.

Après l'apparition du front montant FM du signal E, lorsque la tension de grille (connectée à la ligne 118) atteint la valeur de seuil S2 (instant t1), l'inverseur A2 110 commute avec N passant, P bloqué et V2 = "0". Cette commutation étant validée grâce à la sélection de la voie V2, le niveau de tension "0" est porté à l'entrée 127 de l'inverseur 128, qui commute à son tour pour porter la ligne S 120 au niveau "1". A l'instant t2 correspondant au passage au niveau S1 du front montant FM, l'inverseur A1 112 commute de telle sorte que V1 = V2 = "0" avec le transistor 122 bloqué. Ainsi le niveau de sortie du signal "S" reste égal à "1". A l'instant t'4, lorsque le front montant FM du signal E atteint le niveau TVM, le circuit à hystérésis 140 bascule. La conduction des transistors NMOS 152 et 158 forme un pont résistif diviseur. Le niveau TVM est alors très proche de VDD, simplement distant de VDD de la valeur de la tension de seuil Vt du transistor 150 (de l'ordre de 0,5 volt). La sortie 154 et la ligne 126 prennent donc l'état "0". Le passage au niveau "0" de la ligne 126 entraîne la commutation des transistors 122 et 124 avec un faible retard dû au temps de commutation des inverseurs du circuit tampon 142. Pour résumer, le circuit à seuil se trouve dans un nouvel état stable : E = S = "1" et V1 sélectionnée, cette sélection de V1 permettant de valider la commutation de A1 sur les passages du front descendant FD au seuil S1.

Après l'apparition en t5 du front descendant FD, le processus inverse se produit. A l'instant t6, au passage du seuil S1, l'amplificateur A1 112 commute pour porter V1 à "1" et "S" à "0". Similairement, après l'instant t7, quand le signal E prend la valeur du seuil TVD, la voie V2 est validée par le circuit à hystérésis 140 du circuit pilote 116 qui bascule à l'instant t'9, peu avant le passage du front descendant FD au niveau "bas".

Par conséquent, comme pour le circuit à seuil de la figure 3, le circuit à seuil de la figure 5 permet la mise en oeuvre du procédé selon l'invention, à savoir l'attribution de deux tensions de seuil de déclenchement différentes pour la montée et la descente et la validation du déclenchement du circuit à seuil sur chacune des tensions S1 et S2. Dans le circuit à seuil illustré dans la figure 3, le retard TR du circuit pilote 16 est calculé pour être supérieur ou égal à t2-t1 mais inférieur à t6-t1. Ce circuit à seuil ne peut donc servir que dans une gamme donnée de fréquence du signal E. Il faudrait donc disposer sélectivement de plusieurs circuits de retards différents pour couvrir une large bande de fréquences du signal E. L'avantage du circuit à seuil des figures 4 et 5 réside dans le fait que le circuit pilote 116 structuré sur un circuit 140 du type à hystérésis est indépendant du temps et ne se déclenche que sur ses deux niveaux TVD et TVM. Il est donc indépendant de la fréquence du signal E. En variante, on dispose sélectivement de plusieurs valeurs de niveaux TVD et TVM différents par modification du circuit à hystérésis 140 ou par addition d'une autre bascule.

Dans les deux exemples de circuits CMOS, donnés à titre non limitatif, le procédé est appliqué au déclenchement précoce de circuits. Toutefois, l'invention est également applicable pour réaliser des circuits à déclenchement tardif. On trouvera une application d'un circuit à déclenchement tardif dans la demande de brevet européen EP 0373043 de la demanderesse. En fonctionnement, en référence aux figures 1 et 2 de principe, le déclenchement en t2 de l'amplificateur A1 sur le seuil S1 pendant le front de montée du signal de transmission E produirait la valeur 1 sur la voie V1 et sur la sortie S. La voie V1 devrait alors être inhibée et la voie V2 validée jusqu'à un instant t3 inférieur à t6, de façon que la validation seule de la voie V2 produise le déclenchement de l'amplificateur A2 sur le seuil S2 à l'instant t7 pendant le front de descente. La voie V1 devrait alors être validée et la voie V2 inhibée avant l'instant t1 de la prochaine impulsion du signal E. Par conséquent, le reatrd TR à partir du déclenchement sur le seuil S1 à l'instant t2 devrait être inférieur ou égal au temps t6 - t2 et, à partir du déclenchement sur le seuil S2 à l'instant t7, inférieur ou égal à t0 (suivant) - t7. L'hystérésis devrait suivre les mêmes lois, conformément à l'enseignement de la description qui précède en référence aux figures 4 et 5. A la limite, le retard TR pourrait être nul. Le retard TR nécessaire pour le cas de l'exemple représenté sur la figure 3 pourrait donc en général convenir sans changement pour un déclenchement tardif.

D'une manière générale, on comprend aussi clairement que le multiplexeur pourrait gérer la commande d'un circuit à plus de deux seuils, en sélectionnant les voies V1, V2, ... par un circuit pilote plus perfectionné.

**Revendications**

1. Procédé de déclenchement à seuil d'un signal de transmission E variant entre deux niveaux, respectivement "haut" ou "1" et "bas" ou "0", caractérisé en ce qu'il consiste à attribuer deux tensions de seuil de déclenchement S1 et S2 différentes pour la montée et la descente du signal E et choisies respectivement proches des niveaux "haut"/"1" et "bas"/"0" du signal E, et à valider le déclenchement sur chacune des deux tensions de seuil S1 et S2.

2. Procédé selon la revendication 1, caractérisé en ce que la validation du déclenchement est effectuée sur S2 à la montée et sur S1 à la descente du signal pour un déclenchement précoce ou sur S1 à la montée et sur S2 à la descente pour un déclenchement tardif.

3. Procédé selon la revendication 2, caractérisé en ce que la validation est commandée par introduction d'un retard TR suivant le déclenchement sur une des deux tensions de seuil, le retard TR étant, pour un déclenchement précoce, choisi supérieur ou égal au temps écoulé entre les passages du signal de transmission E sur les deux valeurs de seuil successives d'un même front montant FM ou descendant FD.

4. Procédé selon la revendication 1 ou 2, caractérisé en ce que la validation est commandée lorsque le signal de transmission E atteint une tension de validation de montée TVM ou de descente TVD, ces deux tensions de validation étant définies par les fronts de montée et de descente d'une courbe d'hystérésis.

5. Procédé selon la revendication 4, caractérisé en ce que la tension de validation de montée TVM est choisie supérieure ou égale à la tension du seuil S1, et la tension de validation de descente TVD est choisie inférieure ou égale à la tension de seuil S2.

6. Circuit à seuil pour mettre en oeuvre le procédé selon l'une des revendications précédentes, caractérisé en ce qu'il comprend deux amplificateurs A1, A2 à seuils de déclenchement différents S1, S2, recevant un signal de transmission E et montés en parallèle sur deux voies V1, V2 connectées aux entrées respectives d'un multiplexeur MUX, qui est commandé par un circuit pilote CP pour sélectionner l'une ou l'autre des voies V1, ou V2 selon le front montant FM ou descendant FD du signal de transmission E et pour valider le déclenchement de l'amplificateur A1, A2, qui est monté sur la voie sélectionnée V1, V2, sur la tension de seuil correspondante S1, S2 .

7. Circuit à seuil selon la revendication 6, caractérisé en ce que les valeurs des seuils S1, S2 des amplificateurs A1, A2 dans les voies V1 et V2 sont respectivement choisies au voisinage des niveaux "haut" ou "1" et "bas" ou "0" du s ignal de transmission E.

8. Circuit à seuil selon la revendication 7, caractérisé en ce que le circuit pilote CP (16) commande le multiplexeur MUX (14) pour maintenir la sélection d'une voie V1, V2, après déclenchement de l'amplificateur correspondant A1, A2 au passage du signal de transmission E sur le seuil S1, S2 correspondant, pendant un temps de retard TR qui pour un déclenchement précoce est au moins égal au temps écoulé entre les passages du signal E sur les deux valeurs de seuil successives d'un même front montant FM ou descendant FD.

9. Circuit à seuil selon l'une des revendications 6 à 8, caractérisé en ce que le circuit pilote CP du multiplexeur MUX (14) est du type circuit à retard, commandé de façon optionnelle à partir des signaux de sortie des amplificateurs A1, A2.

10. Circuit à seuil selon la revendication 9, caractérisé en ce que le circuit à retard (16) comprend deux inverseurs CMOS (30, 32) associés à un condensateur de charge intercalaire (34).

11. Circuit à seuil selon la revendication 6 ou 7, caractérisé en ce que le multiplexeur MUX (114) est commandé par le signal de sortie d'un circuit pilote CP (116/140) du type à hystérésis, dont l'entrée reçoit le signal de transmission E.

12. Circuit à seuil selon la revendication 11, caractérisé en ce que le circuit pilote (116) est du type bascule de Schmitt (140), dont les tensions de basculement en montée et descente sont choisies sensiblement égales aux tensions de validation de montée et de descente TVM et TVD.

13. Circuit à seuil selon l'une des revendications 6 à 12, caractérisé en ce que le multiplexeur MUX (14, 114) comprend deux dispositifs de commutation (22-122, 24-124) travaillant en opposition, respectivement montés sur les voies V1 et V2.

14. Circuit à seuil selon la revendication 13, caractérisé en ce que les dispositifs de commutation (22-122, 24-124) sont constitués par deux transistors MOS, un transistor de type N et un transistor de type P dont les grilles sont connectées à la ligne de sortie (26-126) du circuit pilote CP (16-116/140), de façon optionnelle au travers d'un circuit tampon T (142) constitué d'au moins un inverseur CMOS.

FIG_1

FIG. 2

FIG_3

EP 0 490 752 A1

FIG_4

FIG_5

Office européen
des brevets

# RAPPORT DE RECHERCHE EUROPEENNE

Numero de la demande

EP   91 40 3332

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-4 603 264  (NAKANO)<br>* Colonne 2, ligne 52 - colonne 4, ligne 18; figure 2 * | 1,2,6,7,13,14 | H 03 K   17/30<br>H 03 K    3/353 |
| A | --- | 9 | |
| X | PATENT ABSTRACTS OF JAPAN, vol. 8, no. 139 (E-253)[1576], 28 juin 1984; & JP-A-59 47 830 (NIPPON DENKI K.K.) 17-03-1984<br>* Résumé * | 1-4 | |
| A | IDEM<br>--- | 11,12 | |
| X | PATENT ABSTRACTS OF JAPAN, vol. 13, no. 58 (E-714)[3406], 9 février 1989; & JP-A-63 246 925 (MITSUBISHI ELECTRIC CORP.) 13-10-1988<br>* Résumé *<br>--- | 1-3 | |
| A | EP-A-0 072 686  (FUJITSU LTD)<br>* Page 9, lignes 30-35; figure 5 *<br>--- | 10 | |
| A | EP-A-0 154 337  (K.K. TOSHIBA)<br>* Page 18, lignes 17-37; figure 16 *<br>----- | 12 | |

DOMAINES TECHNIQUES RECHERCHES (Int. Cl.5)

H 03 K

Le présent rapport a été établi pour toutes les revendications

| Lieu de la recherche | Date d'achèvement de la recherche | Examinateur |
|---|---|---|
| LA HAYE | 20-03-1992 | CANTARELLI R.J.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)